Europäisches Patentamt

European Patent Office

Office européen des brevets

(11) Veröffentlichungsnummer: **0 217 171**
**A2**

(19)

(12) # EUROPÄISCHE PATENTANMELDUNG

(21) Anmeldenummer: 86112272.9

(22) Anmeldetag: 04.09.86

(51) Int. Cl.⁴: **H01L 29/60** , **H01L 29/80**

(30) Priorität: 01.10.85 DE 3535002

(43) Veröffentlichungstag der Anmeldung:
08.04.87 Patentblatt 87/15

(84) Benannte Vertragsstaaten:
FR GB IT NL

(71) Anmelder: TELEFUNKEN electronic GmbH
Theresienstrasse 2
D-7100 Heilbronn(DE)

(72) Erfinder: Colquhoun, Alexander, Dr.
Burgundenstrasse 5
D-7100 Heilbronn-Frankenbach(DE)

(74) Vertreter: Maute, Hans-Jürgen, Dipl.-Ing.
TELEFUNKEN electronic GmbH
Theresienstrasse 2
D-7100 Heilbronn(DE)

(54) **Sperrschicht-Feldeffekttransistor.**

(57) Die Erfindung betrifft einen Sperrschicht-Feldeffekttransistor mit einem Drainbereich, einem Sourcebereich und einer Gateelektrode zur Beeinflussung eines Kanalgebietes. Die Erfindung besteht hierbei darin, daß der Sourcebereich und die Gateelektrode in der Projektion auf die Kanalebene derart übereinander angeordnet sind, daß die effektive Kanallänge so klein wird, daß eine Erhöhung der Elektronengeschwindigkeit im Kanal erzielt wird.

Fig.1

## Sperrschicht-Feldeffekttransistor

Die Erfindung betrifft einen Sperrschicht-Feldeffekttransistor mit einem Drainbereich, einem Sourcebereich und einer Gateelektrode zur Beeinflussung eines Kanalgebietes.

In jüngster Zeit wurden Sperrschicht-Feldeffekttransistoren insbesondere auf der Basis von Verbindungshalbleitermaterialien mit großer Beweglichkeit der Ladungsträger untersucht und entwickelt, wobei diese Bauelemente insbesondere im Mikrowellenbereich und im Millimeterwellenbereich Verwendung finden.

Es ist bekannt, daß die Gatelänge $L_g$ wesentlich die Hochfrequenzeigenschaften, die Grenzfrequenz und das Rauschverhalten des Sperrschicht-Feldeffekttransistors beeinflussen. Als Gatelänge wird bei bekannten Sperrschicht-Feldeffekttransistoren die Breite der Gateelektrode zwischen Source und Drain bezeichnet.

Es wurden bereits große Anstrengungen unternommen, um die Gatelänge durch technologische Maßnahmen zu reduzieren und damit das Hochfrequenzverhalten der Bauelemente zu verbessern. Eine Reduzierung der Gatelänge ist durch Verfeinerung der Strukturen, beispielsweise durch Elektronenstrahllithographie möglich. Durch die übliche optische Standardlithographie gelang es bis her nur unter Einsatz aufwendiger technologischer Maßnahmen, eine Strukturverkleinerung herbeizuführen, die ausreichend ist, um Sperrschicht-Feldeffekttransistoren im Millimeterwellenbereich und damit bei Frequenzen über 30 GHz zu betreiben.

Der vorliegenden Erfindung liegt daher die Aufgabe zugrunde, einen Sperrschicht-Feldeffekttransistor anzugeben, dessen effektive Kanallänge klein genug ist, um die Transistoren in dem genannten Hochfrequenzbereich betreiben zu können. Hierbei soll der Sperrschicht-Feldeffekttransistor mit einfachen Mitteln herstellbar sein, wobei mit üblichen Standardtechnologien gearbeitet wird. Diese Aufgabe wird erfindungsgemäß dadurch gelöst, daß bei einem Sperrschicht-Feldeffekttransistor der eingangs beschriebenen Art der Sourcebereich und die Gateelektrode in der Projektion auf die Kanalebene derart übereinander angeordnet sind, daß die effektive Kanallänge so klein wird, daß eine Erhöhung der Elektronengeschwindigkeit im Kanal erzielt wird.

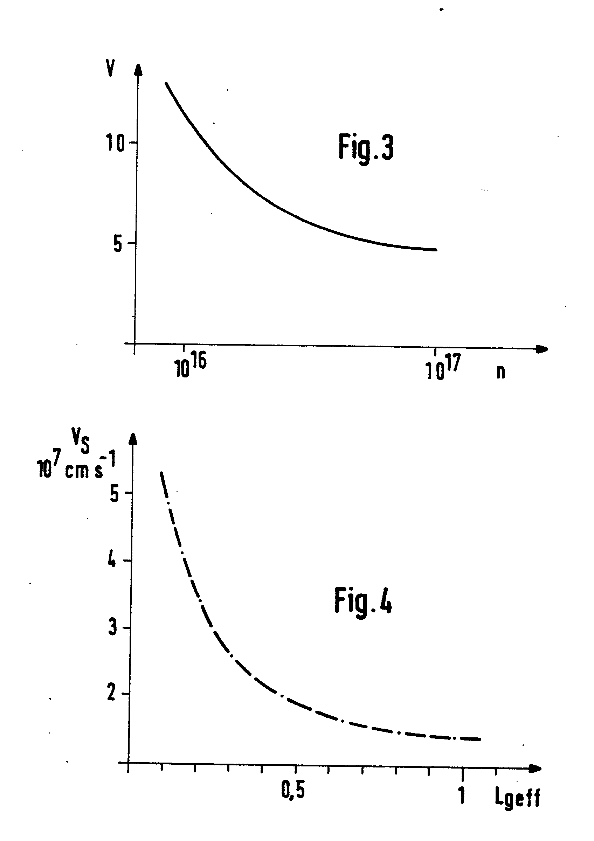

Aus der Zeitschrift "IEE-Proc.-I, 129, 5, pp. 185 -187 vom Okt. 1982" ist es bekannt, daß bei extrem kurzen Kanallängen die Sättigungsgeschwindigkeit der Elektronen im aktiven Kanal stark zunimmt. Dieser Zusammenhang ist in der Figur 4 dargestellt.

Nach der Erfindung werden nun effektive Kanallängen realisiert, die im in der Figur 4 dargestellten Bereich unter 1 μm liegen, in dem eine Erhöhung der Sättigungsgeschwindigkeit der Elektronen im Kanal erfolgt. Die Kanallänge wird hierbei vorzugsweise unter 0,5 μm liegen. Durch die erfindungsgemäße Maßnahme wird erreicht, daß die durch die Gateelektrode vorgegebene Kanallänge aufgrund der Übereinanderanordnung von Gateelektrode und Sourcebereich größer sein kann als die effektive Kanallänge, die elektrisch wirksam wird. Nach der Erfindung kann jede effektive Kanallänge zwischen 0 und 1 μm eingestellt werden, wobei der gewünschte Wert der Kanallänge allein um den Wert der Justiergenauigkeit bei der verwendeten Technologie schwankt. Mit den Standardtechnologien sind Justiergenauigkeiten < 0,1 μm bereits möglich, so daß mit der hierdurch vorgegebenen Genauigkeit effektive Kanallängen zwischen 0 und 1 μm realisiert werden können.

Bei der Erfindung kann die Gateelektrode in der Projektion auf die Kanalebene den Sourcebereich geringfügig in Richtung Drainbereich überlappen. Es besteht jedoch auch die Möglichkeit, daß die dem Drainbereich zugewandte Kante der Gateelektrode in der Projektion auf die Kanalebene mit der dem Drainbereich zugewandten äußeren Kante des Sourcebereiches zusammenfällt. Hierdurch wird ein Sperrschicht-Feldeffekttransistor mit extrem hoher Grenzfrequenz realisiert, wobei die effektive Kanallänge durch die Ausweitung der Raumladungszone von der Kante des Sourcebereichs in Richtung Drainbereich gegeben ist. Durch diese auf den Drainbereich zugerichtete Ausdehnung der Raumladungszone ist es sogar möglich, die dem Drainbereich zugewandte Kante der Gateelektrode in der Projektion auf die Kanalebene um ein Maß x weiter vom Drainbereich entfernt anzuordnen als die äußere Kante des Drainbereiches selbst. Dieses Maß x darf jedoch dann nur so groß sein, daß im Betriebszustand des Transistors der Abschnürbereich im Kanal im Abstand von der äußeren Kan te des Sourcebereichs in Richtung Drainbereich liegt. Dieser Abstand stellt dann die effektive Kanallänge dar.

Weitere Ausgestaltungen der Erfindung werden in den Unteransprüchen beschrieben. Die Erfindung und ihre vorteilhafte Ausgestaltung wird noch anhand der Figuren 1 bis 8 näher erläutert.

Figur 1 zeigt einen Querschnitt durch einen erfindungsgemäß aufgebauten Sperrschicht-Feldeffekttransistor, der

in Figur 2 im kritischen Bereich des Kanals vergrößert dargestellt ist.

Figur 3 zeigt den Zusammenhang zwischen Durchbruchsspannung und Dotierung der über dem Kanal liegenden schwach dotierten Halbleiterschicht.

In Figur 4 ist der bereits erwähnte Zusammenhang zwischen Elektronengeschwindigkeit und effektiver Gatelänge dargestellt.

Figur 5 zeigt in einer Ausschnittvergrößerung die verschiedenen möglichen Zuordnungen zwischen der Ausdehnung der Gateelektrode und der Ausdehnung des darunterliegenden Sourcebereichs.

Figur 6 zeigt eine Technologievariante des erfindungsgemäßen Sperrschicht-Feldeffekttransistors.

Figur 7 zeigt den Sperrschicht-Feldeffekttransistor mit einem zweidimensionalen Elektronengas anstelle des Kanals.

Figur 8 zeigt, wie das kapazitive Verhalten der Anordnung durch Zwischenfügen eines isolierenden Bereiches zwischen Gateelektrode und Sourcebereich weiter verbessert werden kann.

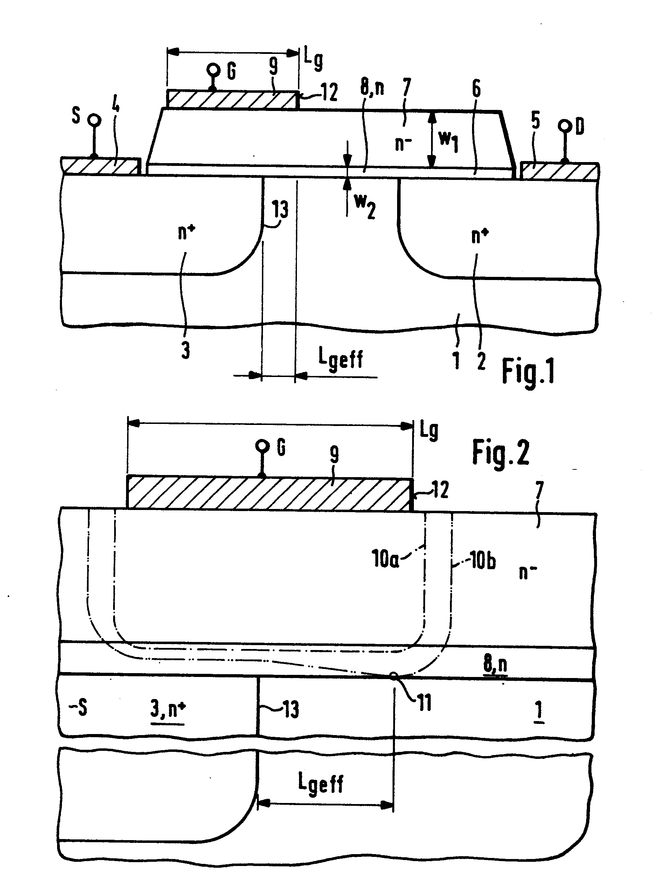

Bei dem in Figur 1 im Querschnitt dargestellten Sperrschicht-Feldeffekttransistor werden in einen hochohmigen Grundkörper 1, der beispielsweise aus Galliumarsenid besteht im Abstand voneinander zwei hochdotierte, $n^+$-leitende Zonen 2 und 3 als Drainbereich und als Sourcebereich eingebracht. Diese Bereiche 2 und 3 können beispielsweise durch Ionenimplantation hergestellt werden und bilden Kontaktzonen mit einer Tiefe von beispielsweise 0,5 $\mu$m oder mehr. An diese Zonen werden im äußeren Randbereich ohmsche Kontakte 4 und 5 als Sourceelektrode bzw. als Drainelektrode angebracht. Auf der Halbleiteranordnung ist eine dotierte Halbleiterschicht 6 angeordnet, die

beispielsweise 0,05 $\mu$m bis 0,2 $\mu$m dick ist und die sich über den Sourcebereich 3 und den Drainbereich 2 erstreckt und somit eine ohmsche Verbindung zwischen diesen Kontaktbereichen herstellt. Der zwischen Source-und Drainbereich 2 bzw. 3 liegende Teil der Schicht 6 bildet den abschnürbaren Kanalbereich 8.

Diese im Ausführungsbeispiel n-leitende Schicht 6 wird beispielsweise durch Epitaxie hergestellt. Auf ihr wird noch vorzugsweise eine schwach $n^-$-dotierte Zone 7 vorgesehen, auf der schließlich die Gateelektrode 9 angeordnet ist. Beim Ausführungsbeispiel bildet die Gateelektrode 9 mit der Halbleiterschicht 7 einen Schottky-Kontakt. Auch die Halbleiterschicht 7 wird vorzugsweise durch Epitaxie hergestellt. Bei der Herstellung der Halbleiteranordnung können die Epitaxieschichten 6 und 7 zunächst ganzflächig den Halbleitergrundkörper bedecken, wobei dann in diese Epitaxieschichten über den Bereichen 2 und 3 Kontaktierungsöffnungen einzubringen sind in denen die ohmschen Kontakte 4 und 5 angeordnet werden. Die schwach dotierte, $n^-$-leitende Schicht 7 hat eine Dicke von vorzugsweise 0,1 bis 0,5 $\mu$m.

Wie aus der Figur 1 deutlich wird, überlappt bei dem dargestellten Ausführungsbeispiel die Gateelektrode 9 in der Projektion auf die Kanalebene die dem Drainbereich zugewandte Kante 13 des Sourcebereiches 3 geringfügig. Diese Überlappung bildet die effektive Kanallänge $L_{geff}$, da die Abschnürstelle des Kanals durch die Raumladungszone 10a bzw. 10b gemäß Figur 2 im wesentlichen durch diese Überlappung definiert ist. Für die Grenzfrequenz eines konventionellen Sperrschicht-Feldeffekttransistors gilt:

$$f_T = \frac{1}{2\pi} \cdot \frac{g_m}{C_{gs}} \qquad (1)$$

wobei $f_T$ die Grenzfrequenz (cutoff-Frequenz) ist, $g_m$ die innere Vorwärtssteilheit des eigentlichen Bauelementes bildet und $C_{gs}$ die Gate-Source-Kapazität darstellt. Durch die Zwischenfügung der schwach dotierten $n^-$-leitenden Schicht 7 wird die Grenzfrequenz $f_T$ nicht vergrößert, da gilt:

$$g_m = \frac{\varepsilon_0 \cdot \varepsilon_r \cdot z \cdot V_s}{W} \qquad (2)$$

$$C_{gs} = \frac{\varepsilon_0 \cdot \varepsilon_r \cdot L_g \cdot z}{W} \qquad (3)$$

wobei W die Eindringtiefe der Raumladungszone, z die Gateweite und $V_s$ die Sättigungsgeschwindigkeit der Elektronen im aktiven Kanal bilden. $L_g$ ist die Kanallänge. Beim Einsetzen der Gleichungen 2 und 3 in die Gleichung 1 kürzt sich W heraus, so daß die Unabhängigkeit der Grenzfrequenz $f_T$ von diesem Wert nachgewiesen ist.

Andererseits bewirkt die schwach dotierte Schicht 7 bei der Anordnung gemäß der Figur 1 eine Vergrößerung der Durchbruchsspannung des Schottky-Kontaktes. Die Einfügung der schwach dotierten Schicht ist deshalb immer dann sinnvoll, wenn relativ hohe Durchbruchsspannungen gewünscht werden. Der Zusammenhang der Durchbruchsspannung V von der Störstellenkonzentration in der Halbleiterschicht 7 ergibt sich aus der Figur 3, woraus ersichtlich ist, daß mit abnehmender Störstellenkonzentration ein Anstieg der Durchbruchsspannung erfolgt. Figur 3 wurde für den spezifischen Fall dargestellt, daß die n⁻-leitende Schicht 7 mit dem eingebauten Potential des Schottky-Kontaktes gerade noch ausgeräumt wird. Die schwach dotierte Schicht 7 ist nicht zwingend erforderlich. Wenn niedere Durchbruchsspannungen zulässig, kann die n⁻-leitende Schicht entfallen.

Wie aus der Gleichung 2 ersichtlich, ist die innere Vorwärtssteilheit $g_m$ von der Driftgeschwindigkeit $V_s$ der Elektronen im Kanal abhängig, so daß die Grenzfrequenz $f_T$ gemäß Gleichung 1 ansteigt, wenn bei abnehmender effektiver Kanallänge gemäß Figur 4 die Driftgeschwindigkeit $V_s$ ansteigt. Wenn daher die effektive Kanallänge $L_{geff}$ gemäß Figur 2 unter 1 $\mu$m und vorzugsweise unter 0,5 $\mu$m sinkt, ergibt sich eine Erhöhung der Grenzfrequenz $f_T$ in einem solchen Ausmaß, daß die Halbleiteranordnung im Mikrowellenbereich und im Millimeterwellenbereich Verwendung finden kann. Außerdem erhält man extrem geringe Rauschzahlen für die Anordnung gemäß Figur 1 bzw. Figur 2. Es gilt:

$$F_{min} = 10 \; Log \left[ 1 + K \cdot f \cdot L_g \sqrt{g_m \; (R_s + R_g)} \right] (5)$$

$F_{min}$ ist hierbei die kleinste Rauschzahl, K ist ein Materialfaktor für das Kanalgebiet, f ist die Frequenz in GHz, $L_g$ ist die Gatelänge und $R_g$ und $R_s$ sind die Gate-bzw. Sourcewiderstände des Bauelementes.

Bei der erfindungsgemäßen Anordnung wird der Sourcewiderstand reduziert, da sich der Sourcebereich 3 unter die Gateelektrode erstreckt. Der Gatewiderstand selbst wird gleichfalls reduziert, da die Gatelänge $L_g$, also die tatsächliche Länge des Schottky-Kontaktes 9, größer gewählt werden kann, als die effektive Kanallänge $L_{geff}$.

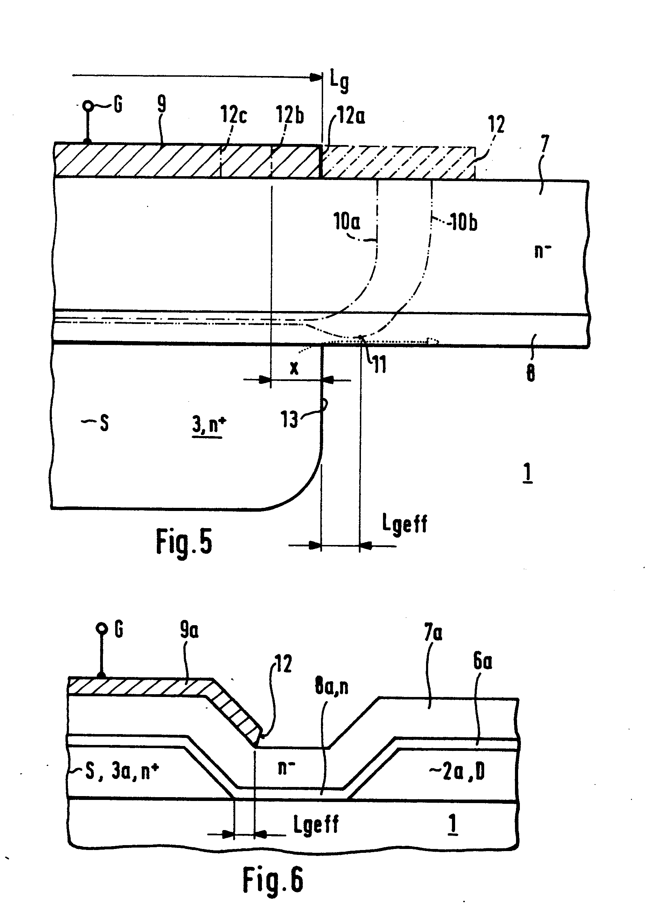

In der Figur 5 ist dargestellt, wie die äußere Kante 12 der Gateelektrode bzgl. der äußeren, dem Drainbereich zugeordneten Kante 13 der Sourceelektrode angeordnet werden kann. Bei der gestrichelten Ausführung der Gateelektrode ist die bereits beschriebene Überlappung zwischen Gateelektrode und Sourcebereich gegeben. Bei der Gateelektrode, die an der Kante 12a endet, ist diese Kante 12a deckungsgleich mit der äußeren Kante 13 des Sourcebereiches. Bei Ausführungsformen, wie sie mit 12b und 12c angedeutet sind, kommt sogar eine Unterlappung zwischen der Gateelektrode 9 und dem Sourcebereich um einen Wert x zustande. Diese Unterlappung ist möglich, da sich die Raumladungszone, wie dargestellt, in den Kanalbereich 8 in Richtung auf den Drainbereich hin erstreckt, so daß die Unterlappung x so groß gewählt werden kann, daß der Abschnürbereich 11 gerade noch im Kanal 8 zwischen dem Sourcebereich 3 und dem Drainbereich 2 liegt. Der Abstand des Abschnürbereiches 11 zur äußeren Kante 13 des Sourcebereiches bildet dann die effektive Kanallänge des Sperrschicht-Feldeffekttransistors.

Bei den beschriebenen Ausführungsbeispielen beträgt die Ladungsträgerkonzentration in der schwach dotierten Schicht 7 vorzugsweise $10^{16}$ bis $10^{17}$ Ladungsträger/cm³, im Kanal 6 bzw. 8 vorzugsweise $10^{17}$ bis $10^{18}$ Ladungsträger/cm³ und in den hochdotierten Bereichen 2 und 3 liegt die Störstellenkonzentration vorzugsweise über $10^{18}$ Ladungsträger/cm³. Da bei den erfindungsgemäßen Anordnungen über der Kanalzone eine schwach dotierte Zone 7 angeordnet ist, kann die Kanalzone selbst relativ hoch dotiert werden. Diese hat den Vorteil, daß die Verstärkungseigenschaften des Sperrschicht-Feldeffekttransistors mit zunehmender Konzentration im Kanalbereich verbessert werden.

Die Sperrschicht-Feldeffekttransistoren nach der Erfindung werden vorzugsweise mit Hilfe von Epitaxialprozessen hergestellt, wobei für diese Prozesse eine große Gleichmäßigkeit und perfekte Schichtübergänge zwischen den einzelnen gewachsenen Schichten gefordert wird. Dies kann beispielsweise durch metallorganische, chemische Dampfepitaxieprozesse oder durch Molekularstrahlepitaxie erreicht werden. Das schwach dotierte oder undotierte semiisolierende Substrat 1 kann auch durch eine epitaktisch gewachsene Zwischenschicht ersetzt werden, in die dann die Source-und die Drainbereiche 2 bzw. 3 durch Ionenimplantation eingebracht werden. Auf diese Weise lassen sich tiefe Störstellen im Grenzbereich zwischen der Kanalzone und dem Grundmaterial vermeiden.

Die Struktur gemäß Figur 1 kann durch eine Struktur gemäß Figur 6 ersetzt werden. Beim Ausführungsbeispiel der Figur 6 sind die Source- und Drainbereiche 2a bzw. 3a Teil einer auf einem Grundkörper 1 aufgebrachten Schicht, die im mittleren Bereich wieder abgetragen wird. Auf die so erzeugte Struktur wird sodann die n-dotierte Schicht 6a aufgebracht, deren auf dem Halbleiterkörper 1 angeordneter Teil zwischen dem Drainbereich 2a und dem Sourcebereich 3a den Kanal 8a bildet. Die Schicht 6a wird schließlich noch mit der epitaktisch aufgebrachten und sehr schwach dotierten Schicht 7a bedeckt und abschließend wird auf diese schwach dotierte Schicht 7a die Gateelektrode 9a so aufgebracht, daß eine geringfügige Überlappung zwischen der Kante 12 der Gateelektrode und der inneren Kante des Sourcebereichs 3a zustande kommt, wodurch die effektive Gatelänge $L_{geff}$ definiert wird.

Bei den beschriebenen Sperrschicht-Feldeffekttransistoren fließt der Source-Drain-Strom niemals unmittelbar an der Oberfläche des Bauelementes. Der aktive Teil des Transistors ist vielmehr von der Halbleiteroberfläche soweit beabstandet, daß die Materialstörungen, die im Oberflächenbereich auftreten, die elektrischen Eigenschaften des Bauelementes nicht beeinflussen. Dies verbessert die elektrischen Eigenschaften des erfindungsgemäßen Sperrschicht-Feldeffekttransistors wesentlich.

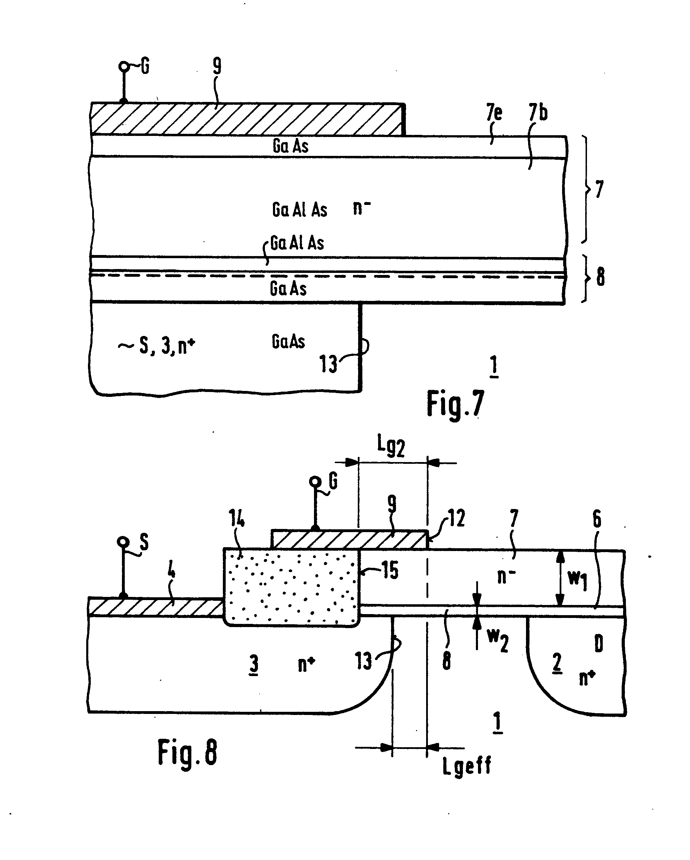

Der aktive Kanal bei den bisher beschriebenen Anordnungen kann auch durch ein leitendes zweidimensionales Elektronengas gemäß Figur 7 ersetzt werden. Diese Strukturen werden vielfach als HEMT-, MODFET-oder TEGFET-Strukturen bezeichnet. Solche Strukturen sind beispielsweise aus der Zeitschrift "Jap. J. Appl. Physics, Vol. 19, No. 5, 1980, p. 225 -227" bekannt. Der Kanalbereich ist bei einer derartigen Struktur durch den Grenzbereich eines Heteroübergangs zwischen einer GaAs-Schicht und einer GaAlAs-Schicht definiert. Die hochohmige Schicht 7 ergibt sich aus einer schwach dotierten Galliumaluminiumarsenidschicht 7b und aus einer darauf angeordneten Kontaktschicht 7c aus Galliumarsenid. Andere Strukturen zur Erzeu-gung des zweidimensionalen leitenden Elektronen-gases sind gleichfalls denkbar.

In Figur 8 ist schließlich noch dargestellt, wie die kapazitiven Eigenschaften des Sperrschicht-Feldeffekttransistors weiter verbessert werden können. Hierzu wird ein Bereich 14 zwischen der Gateelektrode 9 und dem Sourcebereich 3 aus iso-lierendem Material 14 gebildet. Auf dieses isolierende Material erstreckt sich dann die Gateelektrode in ihrem dem Drainbereich 2 abgewandten Teil. Der isolierende Bereich 14 kann gleichfalls durch Ionenimplantation erzeugt werden, indem beispielsweise Bor oder Sauerstoff in die Halbleiterschichten 6 und 7 implantiert werden, bis der Implantationsbereich Isolationseigenschaften annimmt. Eine andere Möglichkeit besteht darin, partiell Siliziumdioxid oder Siliziumnitrid in vorher erzeugten Isolationsfenstern abzuscheiden und danach die Gateelektrode 9 so anzuordnen, daß sie sich vom Isolationsbereich 14 über die schwach dotierte Halbleiterschicht 7 erstreckt.

Die Kapazität des isolierten Gebietes 14 unter der Gateelektrode wird auf diese Weise reduziert, so daß die Gatekapazität im wesentlichen nur noch durch den Abstand zwischen der inneren Kante 15 des isolierenden Gebietes 14 und der inneren Kante 12 der Gateelektrode bestimmt wird. Dieser Teil der Gatelänge ist mit $L_{g2}$ bezeichnet. Die übrigen in der Figur 8 dargestellten Teile des Sperrschicht-Feldeffekttransistors entsprechen den bereits anhand der vorangehenden Figuren be-schriebenen Teile.

## Ansprüche

1) Sperrschicht-Feldeffekttransistor mit einem Drainbereich (2), einem Sourcebereich (3) und einer Gateelektrode (9) zur Beeinflussung eines Kanalgebietes (8), dadurch gekennzeichnet, daß der Sourcebereich (3) und die Gateelektrode (9) in der Projektion auf die Kanalebene derart übereinander angeordnet sind, daß die effektive Kanallänge - ($L_{geff}$) so klein wird, daß eine Erhöhung der Elektronengeschwindigkeit im Kanal (8) erzielt wird.

2) Sperrschicht-Feldeffekttransistor nach Anspruch 1, dadurch gekennzeichnet, daß die Gateelektrode (9) in der Projektion auf die Kanalebene den Sourcebereich (3) geringfügig in Richtung Drainbereich (2) überlappt.

3) Sperrschicht-Feldeffekttransistor nach Anspruch 2, dadurch gekennzeichnet, daß die im wesentlichen die effektive Kanallänge ($L_{geff}$) bestimmende Überlappung kleiner als 1 $\mu$m ist.

4) Sperrschicht-Feldeffekttransistor nach Anspruch 2, dadurch gekennzeichnet, daß sich die dem Drainbereich (2) zugewandte Kante (12a) der Gateelektrode (9) in der Projektion auf die Kanalebene mit der dem Drainbereich (2) zugewandten äußeren Kante (13) des Sourcebereichs (3) deckt.

5) Sperrschicht-Feldeffekttransistor nach Anspruch 2, dadurch gekennzeichnet, daß die dem Drainbereich (2) zugewandte Kante (12b, 12c) der Gateelektrode (9) in der Projektion auf die Kanalebene um das Maß x weiter vom Drainbereich (2) entfernt ist als die äußere Kante (13) des Drainbereichs (3), wobei x nur so groß sein darf, daß im Betriebszustand des Transistors der Abschnürbereich (11) im Kanal im Abstand ($L_{geff}$) von der äußeren Kante (13) des Sourcebereichs (3) in Richtung Drainbereich (2) liegt.

6) Sperrschicht-Feldeffekttransistor nach einem der vorangehenden Ansprüche, dadurch gekennzeichnet, daß die Gateelektrode (9) mit dem Halbleiterkörper einen Schottky-Kontakt bildet.

7) Sperrschicht-Feldeffekttransistor nach einem der vorangehenden Ansprüche, dadurch gekennzeichnet, daß die effektive Kanallänge ($L_{geff}$) zwischen 0 und 1 $\mu$m gewählt ist und daß die Genauigkeit in der Einstellung der Kanallänge durch die Justiergenauigkeit des technologischen Herstellungsverfahrens vorgegeben ist.

8) Sperrschicht-Feldeffekttransistor nach einem der vorangehenden Ansprüche, dadurch gekennzeichnet, daß der Sourcebereich (3) und der Drainbereich (2) hochdotierte Zonen in einem hochohmigen Halbleiterkörper (1) sind, die sich unter eine dotierte Zone (6) gleichen Leitungstyps erstrecken, deren zwischen dem Sourcebereich (3) und dem Drainbereich (2) liegender Teil (8) den Kanal bildet.

9) Sperrschicht-Feldeffekttransistor nach Anspruch 8, dadurch gekennzeichnet, daß zwischen der Gateelektrode (9) und der hochdotierten, den Kanal (8) enthaltenden Zone (6) eine schwach dotierte Zone (7) vom Leitungstyp des Kanals (8) angeordnet ist.

10) Sperrschicht-Feldeffekttransistor nach Anspruch 8 oder 9, dadurch gekennzeichnet, daß die hochdotierte, den Kanal (8) enthaltende Zone (6) ca. 0,05 -0,2 $\mu$m und die darüber angeordnete schwach dotierte Zone (7) gleichen Leitungstyps ca. 0,1 -0,5 $\mu$m dick ist.

11) Sperrschicht-Feldeffekttransistor nach einem der vorangehenden Ansprüche, dadurch gekennzeichnet, daß die Drain-und Sourcebereiche (2, 3) aus in den Halbleitergrundkörper (1) implantierten, hochdotierten Zonen bestehen oder Teile (2a, 3a) einer auf den Halbleitergrundkörper aufgebrachten hochdotierten Schicht sind.

12) Sperrschicht-Feldeffekttransistor nach einem der vorangehenden Ansprüche, dadurch gekennzeichnet, daß der leitende Kanal (8) aus einem zweidimensionalen Elektronengas (Fig. 7) besteht.

13) Sperrschicht-Feldeffekttransistor nach einem der vorangehenden Ansprüche, dadurch gekennzeichnet, daß an dem dem Drainbereich abgewandten Ende zwischen der Gateelektrode (9) und dem Sourcebereich (3) ein isolierendes Gebiet (14) angeordnet ist.

14) Sperrschicht-Feldeffekttransistoren nach Anspruch 13, dadurch gekennzeichnet, daß das isolierende Gebiet (14) durch Ionenimplantation erzeugt ist und daß der Abstand zwischen der äußeren Kante (15) des isolierenden Gebietes und der dem Drainbereich (2) zuge wandten Kante (13) des Sourcebereichs möglichst klein gehalten wird, während das isolierende Gebiet (14), die dem Drainbereich abgewandte Kante der Gateelektrode (9) überlappt.

15) Sperrschicht-Feldeffekttransistor nach einem der vorangehenden Ansprüche, dadurch gekennzeichnet, daß als Halbleitermaterial III/V Verbindungsmaterial, insbesondere GaAs, Verwendung findet.

Fig.1

Fig.2

Fig.3

Fig.4

Fig.5

Fig.6

Fig.7

Fig.8